Europäisches Patentamt

European Patent Office

Office européen des brevets

(19)

(11) **EP 0 473 816 B1**

(12) **EUROPÄISCHE PATENTSCHRIFT**

(45) Veröffentlichungstag und Bekanntmachung des Hinweises auf die Patenterteilung:
**06.08.1997 Patentblatt 1997/32**

(51) Int Cl.6: **H03L 7/18**, H03K 7/06

(21) Anmeldenummer: **90116904.5**

(22) Anmeldetag: **03.09.1990**

(54) **Verfahren zur Spannungs-Frequenz-Wandlung**

Process for voltage-frequency conversion

Procédé pour la coversion tension-fréquence

(84) Benannte Vertragsstaaten:
**CH DE ES FR GB IT LI SE**

(43) Veröffentlichungstag der Anmeldung:
**11.03.1992 Patentblatt 1992/11**

(73) Patentinhaber: **SIEMENS AKTIENGESELLSCHAFT**
**80333 München (DE)**

(72) Erfinder: **Hartwig, Hagen, Dipl.-Ing.**
**D-8520 Erlangen (DE)**

(56) Entgegenhaltungen:
**WO-A-90/11646          US-A- 3 260 943**

• **UKW BERICHTE, März 1987, Seiten 130-140, Baiersdorf, DE; J. JIRMANN: "Ein Spektral-Analysator für Amateure"**

**Beschreibung**

Die Erfindung bezieht sich auf ein Verfahren und auf eine Einrichtung zur Spannungs-Frequenz-Wandlung.

Die Wandlung eines kontinuierlichen Signals in ein diskontinuierliches Signal bringt für eine Reihe von Anwendungen Vorteile mit sich. Deshalb werden Spannungs-Frequenz-Wandler in den verschiedensten Gebieten der Elektrotechnik und Elektronik verwendet. Beispielsweise lassen sich bei der Regelung von Elektromotoren die Strom- bzw. Spannungsistwerte durch Wandlung in eine dem Strom- bzw. Spannungsistwert proportionale Folge von Impulsen leicht in ein digitales Regelungskonzept integrieren.

Zur Einbindung der Spannungs- bzw. Stromistwerterfassung, beispielsweise in ein Regelungskonzept eines Elektromotors, ist es vorteilhaft, das kontinuierliche Signal am Ort seiner Erfassung zu digitalisieren und beispielsweise in Form von Impulsen unterschiedlicher Impuls-Folgefrequenz zu übertragen. Selbst bei einer analogen Regelung kann es wegen der hohen Störsicherheit von Vorteil sein, zunächst digitale Signale für die Signalübertragung zu verwenden und diese dann anschließend wieder in ein kontinuierliches Signal zu transformieren.

Wegen der in vielen Anwendungsfällen geforderten Kleinheit der Abmessungen bei äußerst schneller und hochgenauer Digitalisierung eines Eingangssignals und bei großem Frequenzhub bei möglichst geringen Kosten kann nicht immer auf herkömmliche, auf dem Markt erhältliche Spannungs-Frequenz-Wandler zurückgegriffen werden.

In der älteren internationalen Anmeldung mit dem Aktenzeichen PCT/DE 89/00197, die als WO-A-90/11646 am 4.Oktober 1990 nach dem Anmeldetag veröffentlicht ist, wurde bereits ein Verfahren zur Spannungs-Frequenz-Wandlung vorgeschlagen mit dem ein schneller und hochgenauer Spannungs-Frequenz-Wandler mit großem Frequenzhub realisiert werden kann. Dabei wird ein herkömmlicher integrierender spannungsgesteuerter Oszillator verwendet, der durch eine präzise Regelung ein hochgenaues Frequenzsignal (Pulsfolge-Signal) abgibt. Für diese Regelung wird das Ausgangssignal des spannungsgesteuerten Oszillators im wesentlichen über ein Präzisionsmonoflop, das durch einen Quarzoszillator getaktet wird, einen Praszisionsschalter und einen Tiefpaß, in eine Gleichspannung zurückverwandelt, mit der Eingangsspannung des spannungsgesteuerten Oszillators verglichen und zur Regelung desselben herangezogen.

Die - beispielsweise für die Regelung von Elektromotoren - geforderte Genauigkeit für das Frequenzsignal das spannungsgesteuerten Oszillators liegt bei 0,5 ‰. Bei sehr hohen Frequenzen des Frequenzsignals (Impulsdauer ca. 100 ns) läßt sich diese Genauigkeit kaum erzielen. Außerdem kann es zu Schwebungen bei der Bildung der Präzisionsimpulse durch das Präzisionsmonoflop und damit zu Ungenauigkeiten in der Regelung kommen.

Mit dem in der internationalen Anmeldung (PCT/DE 89/00197 die als WO-A-90/11646 am 4. Oktober 1990 nach dem Anmeldetag veröffentlicht ist) beschriebenen Spannungs-Frequenz-Wandler läßt sich zwar unmittelbar eine genaue digitale Auswertung in einem weiten Frequenzbereich erzielen, für eine analoge Auswertung müssen jedoch bei hohen Frequenzen zusätzliche Maßnahmen getroffen werden.

Aus der US-Patentschrift US-A-3 260 943 ist ein Verfahren bekannt, bei dem die Einzelimpulse des Ausgangssignales eines Frequenzteilers mit Hilfe eines weiteren Frequenzteilers in eine Impulsfolge mit konstanter Pulsbreite gewandelt werden. Darauf folgend wird die Amplitude dieser Impulse so geregelt, daß Präzisionsimpulse erzeugt werden. Durch die darin offenbarte Ansteuerung eines spannungsgesteuerten Oszillators ist der zu erzielende Frequenzhub jedoch gering und eine sehr schnelle Wandlung nur über einen eingeschränkten Frequenzbereich realisierbar.

Aufgabe der Erfindung ist es, mit einfachen Mitteln ein Verfahren und eine Einrichtung zur Spannungs-Frequenz-Wandlung bei großem Frequenzhub zu realisieren.

Diese Aufgabe wird durch ein Verfahren zur Spannungs-Frequenz-Wandlung nach folgenden Verfahrensschritten gelöst:

a) Ein integrierender, spannungsgesteuerter Oszillator wird mit einer Eingangsspannung beaufschlagt, die über eine Pegelanpaßschaltung führbar ist,

b) das Ausgangssignal des spannungsgesteuerten Oszillators wird einem Frequenzteiler zugeführt,

c) die Einzelimpulse des Ausgangssignals des Frequenzteilers werden in eine Impulsfolge mit konstanter Pulsbreite gewandelt und anschließend in ihrer Amplitude so geregelt, daß Impulse mit konstantem Flächeninhalt als Präzisionsimpulse erzeugt werden, dadurch gekennzeichnet, daß

d) aus den Präzisionsimpulsen eine Gleichspannung gebildet wird,

e) aus der Gleichspannung und einer Eingangsspannung eine Differenzspannung gebildet wird, die dem spannungsgesteuerten Oszillator über einen Regler zur Regelung aufgeschaltet wird.

Die Teilung der Frequenz des Ausgangssignals des spannungsgesteuerten Oszillators ermöglicht eine vorteilhafte Ausbildung der Erfindung bei der die Impulsfolge mit konstanter Pulsbreite mit einem Impulszähler erzeugt wird, wobei der Impulszähler während einer vorgebbaren Anzahl von Zählertaktsignalen ein Ausgangssignal logisch "1" abgibt. Ebenfalls bedingt durch die Frequenzteilung kann auch die Frequenz des Zählertaktsignals geringer gehalten werden und trotzdem noch das Abtasttheorem bezüglich des Ausgangssignals des Frequenzteilers eingehalten werden.

Die Verwendung von gängigen Quarzoszillatoren stellt dabei eine einfache, aber sehr genaue Möglichkeit zur Erzeugung des Zählertaktsignals dar.

Das Zählertaktsignal kann aber auch von einem RC-Glied abgeleitet werden, wobei die Zeitkonstante des RC-Gliedes die Dauer der Zähltaktimpulse bestimmt. Diese Ausführungsform wird zwar bei hohen Frequenzen des Zählertaktsignals nicht die Genauigkeit eines Quarzoszillators erreichen, stellt aber im mittleren Anwendungsbereich eine wirtschaftliche Lösung dar.

Ein Sonderfall der zuletzt genannten Ausführungsform ergibt sich, wenn der Impulszähler nur jeweils einen Impuls des Ausgangssignals des Frequenzteilers zählt. Dadurch kann wiederum die Frequenz des von einem RC-Glied abgeleiteten Zählertakt- / signals reduziert werden und somit dessen Genauigkeit erheblich gesteigert werden.

Bei dem beschriebenen Sonderfall wirkt der Impulszähler nach außen wie ein Monoflop. Dies führt zu einer weiteren vorteilhaften Ausbildung der Erfindung, bei der die Impulsfolge mit konstanter Pulsbreite mit einem getakteten bistabilen Schalter erzeugt wird, wobei das Taktsignal des bistabilen Schalters aus einem RC-Glied abgeleitet wird.

Bei vielen, auch bereits in Betrieb befindlichen Einrichtungen ist eine digitale Regelung noch nicht vorgesehen. Aber auch für diese Einrichtungen kann das Verfahren zur Spannungs-Frequenz-Wandlung vorteilhaft angewendet werden, wenn nach einer weitere Ausbildung der Erfindung zu den Präzisionsimpulsen invertierte Präzisionsimpulse erzeugt werden, wobei aus der Summe der Präzisionsimpulse und der invertierten Präzisionsimpulse eine Regelgröße gebildet wird, mit der die jeweilige Versorgungsspannung der Einrichtungen zur Erzeugung der Präzisionsimpulse so geregelt wird, daß die Flächeninhalte eines jeweiligen Präzisionsimpulses und eines jeweiligen invertierten Präzisionsimpulses gleich sind. Durch diese Maßnahme werden Abweichungen der Ein- und Ausschaltflanken der Präzisionsimpulse kompensiert und somit die Voraussetzungen für eine genaue analoge Weiterverarbeitung geschaffen.

Bei einer vorteilhafteren Ausführungsform für die analoge Auswertung wird sowohl die positive als auch die negative Versorgungsspannung der jeweiligen Einrichtungen zur Erzeugung der Präzisionsimpulse so geregelt, daß die Summe ihrer Beträge konstant und die Präzisionsimpulse symmetrisch um eine vorgebbare Mittelspannung liegen. Damit kann ein Offset kompensiert werden, ohne die Gesamtverstärkung zu beeinflussen.

Die geregelten Präzisionsimpulse oder die geregelten invertierten Präzisionsimpulse lassen sich über eine Übertragungsstrecke übertragen und anschließend beispielsweise über einen Tiefpaß zur analogen Weiterverarbeitung in eine Gleichspannung umwandeln.

Wird das Verfahren zur Spannungs-Frequenz-Wandlung beispielsweise für ein digitales Regelungskonzept verwendet, ist eine Ausbildung der Erfindung vorteilhaft, bei der die Impulse des Ausgangssignals des integrierenden, spannungsgesteuerten Oszillators in einer Auswertelogik in einem vorgebbaren Zeitraum mit vorgebbarer Periode gezählt werden. Die Anzahl der Impulse pro Zeiteinheit ist damit direkt proportional zur Eingangsspannung. Selbstverständlich könnten auch andere Formen der Mittelwertbildung verwendet werden. Diese digitale Auswertung zeichnet sich durch hohe Störsicherheit aus und erlaubt es, die Impulse über eine größere Übertragungsstrecke ohne Einschränkungen der Genauigkeit zu übertragen, da selbst eine "Verschleifung" der Impulse im Verlauf der Übertragung ohne Auswirkungen auf die Genauigkeit des Verfahrens bleibt, solange die Impulse durch die Auswerteeinrichtung noch als solche erkannt werden können.

Mit zwei weiteren vorteilhaften Ausbildungen der Erfindung, die sich auf die digitale Auswertung beziehen, läßt sich eine Quasi-Frequenzverdopplung des Ausgangssignals des spannungsgesteuerten Oszillators erzielen. Bei einer ersten Ausbildung enthält die Auswertelogik einen digitalen Zähler, wobei als Taktsignal des Zählers jeweils die positive und negative Flanke eines Pulses des Ausgangssignals des spannungsgesteuerten Oszillators verwendet wird.

Bei einer zweiten Ausbildung enthält die Auswertelogik ebenfalls einen digitalen Zähler, wobei der Zähler mit dem Ausgangssignal des spannungsgesteuerten Oszillators getaktet wird und wobei das Ausgangssignal des spannungsgesteuerten Oszillators als eine weitere Binärstelle darstellendes Ausgangssignal zu den Ausgangssignalen des Zählers verwendet wird.

Ein Ausführungsbeispiel der Erfindung ist in der Zeichnung dargestellt und wird im folgenden näher erläutert. Dabei zeigen

FIG 1    das Blockschaltbild einer Einrichtung zur Spannungs-Frequenz-Wandlung mit digitaler Signalweiterverarbeitung,

FIG 2    ein über ein RC-Glied getaktetes Monoflop,

FIG 3    das Blockschaltbild einer Einrichtung zur Spannungs-Frequenz-Wandlung mit analoger Signalweiterverarbeitung,

FIG 4    ein Blockschaltbild einer Einrichtung zur analogen Signal-weiterverarbeitung mit symmetrischer Mittelpunktsspannung,

FIG 5    das Blockschaltbild einer Einrichtung mit digitaler und analoger Signalweiterverarbeitung.

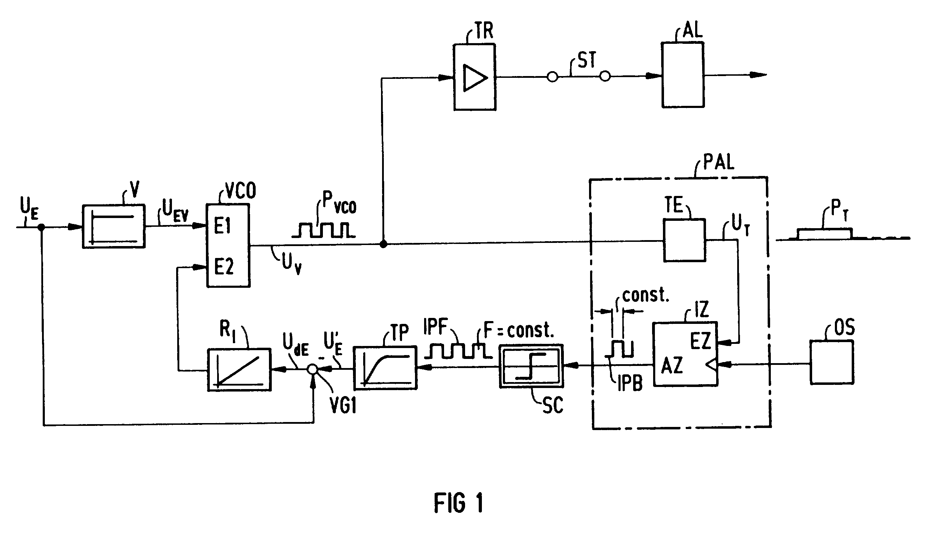

Das Blockschaltbild gemäß FIG 1 stellt eine Möglichkeit zur Ausführung des erfindungsgemäßen Verfahrens dar. Es besteht aus einem Verstärker V zur Pegelanpassung einer Eingangsspannung $U_E$. Die Ausgangsspannung $U_{EV}$ des Verstärkers V wird auf einen ersten Eingang E1 eines integrierenden, spannungsgesteuerten Oszillators VCO geführt. Wegen der für die Auswertung des digitalen Signals erforderlichen Mittelwertbildung ist eine integrierende Arbeitsweise des spannungsgesteuerten Oszillators VCO erforderlich. Der integrierende spannungsgesteuerte Oszillator VCO liefert Einzelimpulse $P_{VCO}$, deren Häufigkeit proportional zur Höhe der Eingangsspannung $U_{EV}$ ist. Als integrierender spannungsgesteuerter Oszillator VCO (Voltage Controlled Oszillator) kann beispielsweise ein emittergekoppelter Multivibrator, der unter der Bezeichnung LS 624 im Handel erhältlich ist, verwendet werden. Ein solcher spannungsgesteuerter Oszillator VCO zeichnet sich durch einen großen Frequenzbereich (ca. 2 bis 42 MHz) aus. Jedoch muß für diesen großen Frequenzhub eine geringere Genauigkeit des Ausgangssignals $U_V$ (Puls folge-Signal) in Kauf genommen werden.

Wegen der Ungenauigkeit des spannungsgesteuerten Oszillators wird dessen Ausgangssignal $U_V$ über eine Regelstrecke in eine Gleichspannung $U_E^{'}$ zurückgewandelt. Diese Regelstrecke besteht aus einem Frequenzteiler TE, einem Impulszähler IZ, einem Schalter SC und einem Tiefpaß TP.

Der mit einem Dreieck gekennzeichnete Takteingang des Impulszählers IZ ist mit einem Oszillator OS, der vorzugsweise ein Quarzoszillator ist, verbunden. Der Frequenzteiler TE sowie der Impulszählers IZ können, wie durch die gestrichelte Einrahmung angedeutet, durch einen PAL (Programmable Array-Logic) realisiert sein.

Durch den Frequenzteiler wird die Frequenz des Frequenzsignals $P_{VCO}$ am Ausgang des VCO reduziert. Bei einer Frequenz des Frequenzsignals $P_{VCO}$ von 10 MHz und einem Teilverhältnis des quenzteilers TE von 64 : 1 liegt die Frequenz des Teilerausgangssignals $U_R$ bei ca. 150 kHz. Es werden also Impulse $P_T$ mit längerer Impulsdauer verglichen mit den Impulsen $P_{VCO}$ des spannungsgesteuerten Oszillators VCO, erzielt. Die durch die Ein- und Ausschaltflanken der Impulse bedingten Fehler bleiben jedoch gleich, so daß die Fehler der Impulse $P_T$ des Frequenzteilers TE bezogen auf die längere Impulsdauer minimiert werden.

Der Impulszähler IZ hat zusammen mit dem Oszilator OS die Aufgabe, zu jedem Impuls $P_T$ des Augsngssignals $U_T$ des Frequenzteilers TE einen Präzisionsimpuls IPB mit konstanter Pulsbreite zu erzeugen. Sobald am Eingang EZ des Impulszählers IZ und an seinem Takteingang ein Signal logisch "1" anliegt, gibt der Impulszähler ein Signal logisch "1" an seinen Ausgang AZ ab.

Das Ausgangssignal des Impulszählers wird auf logisch "0" gesetzt, wenn dieser eine vorgegebene Anzahl von Taktsignalen des Oszillators OS gezählt hat. Damit ist ist gewährleistet, daß zu jedem Impuls $P_T$ des Frequenzteilers TE ein Präzisionsimpuls IPB mit konstanter Impulsbreite am Ausgang des Impulszählers erzeugt wird. Bei einer technisch realisierten Ausführung hat der Oszillator eine Frequenz von 26 MHz und die Präzisionsimpulse werden aus 127 Impulsen des Quarzoszillators gebildet.

Der Präzisionsschalter SC erzeugt aus den Präzisionsimpulsen IPB mit konstanter Pulsbreite Präzisionsimpulse IPF mit konstantem Flächeninhalt indem er die Präzisionsimpulse IPB mit konstanter Spannungsamplitude an seinen Ausgang durchschaltet. Über den Tiefpaß TP werden nun die Präzisionsimpulse IPF in eine Gleichspannung $U_E^{'}$ umgewandelt. Diese Gleichspannung $U_E^{'}$ wird am Vergleicher VG1 von der Eingangsspannung $U_E$ subtrahiert und die Differenzspannung $U_{dE}$ wird über einen Regler $R_I$ dem spannungsgesteuerten Oszillator VCO als Regelgröße aufgeschaltet. Am Ausgang des VCO entsteht somit ein geregeltes Ausgangssignal $U_V$ als Impulsfolgesignal in Form von Einzelimpulsen P, deren Häufigkeit proportional zur Höhe der Eingangsspannung $U_E$ ist. Dieses Ausgangssignal $U_V$ kann nun über eine Treiberstufe TR und eine Übertragungsstrecke ST an eine Auswertelogik AL gegeben werden, in der eine der Eingangsspannung $U_E$ proportionale Größe für die weitere Verarbeitung gebildet wird. Die weitere Verarbeitung der Impulsfolgefrequenz kann dabei variieren in Bezug auf die Wahl der Abtastzeitpunkte und verschiedene Arten der Mittelwertbildung. Auf eine spezielle Art der Auswertung wird weiter unten noch eingegangen.

Anstelle eines Quarzoszillators für den Oszillator OS kann das Taktsignal für den Impulszähler IZ auch aus einem RC-Glied abgeleitet werden. Die Dauer des Taktsignals würde dann durch die Zeitkonstante des RC-Glieds bestimmt werden.

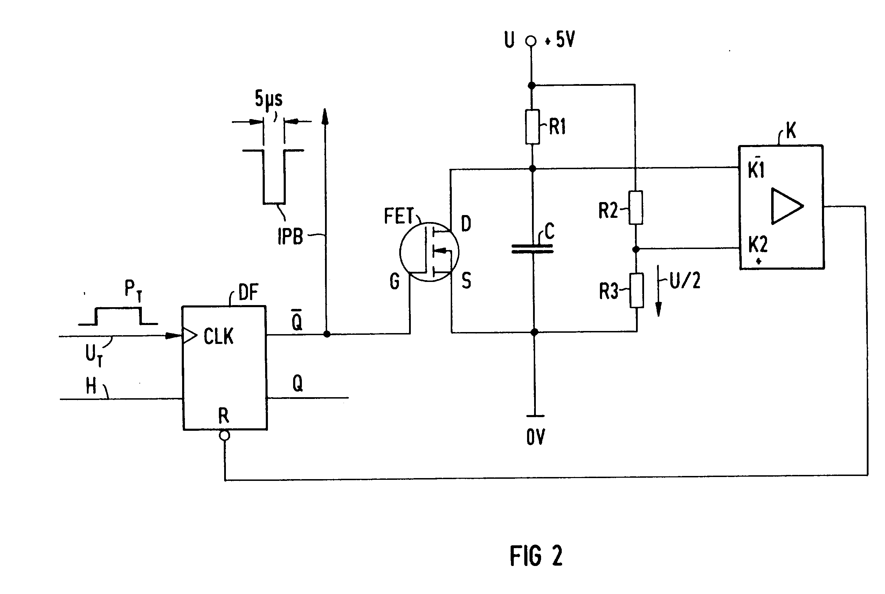

Anstelle des oszillatorgetakteten Impulszählers IZ lassen sich die Präzisionsimpulse IPB mit konstanter Pulsbreite auch mittels eines getakteten bistabilen Schalters erzeugen. Diese Möglichkeit wird im folgenden anhand der FIG 2 beschrieben.

FIG 2 zeigt ein D-Flip-Flop DF als bistabilen Schalter. Die Restzeit des D-Flip-Flops DF wird von einem RC-Glied, das aus dem Widerstand R1 und dem Kondensator C besteht abgeleitet. Auf den Takteingang CLK des D-Flip-Flops DF wird das Ausgangssignal $U_T$ des Frequenzteilers TE (FIG 1) gegeben. Am Ausgang $\underline{Q}$ (der Unterstrich bedeutet den negierten Ausgang, wobei es dem Fachmann überlassen bleibt, welchen Ausgang er verwenden will) des D-Flip-Flops DF sind die Präzisionsimpulse IPB mit konstanter Pulsbreite abgreifbar. Zur Erzeugung der konstanten Impulsbreite ist der Ausgang $\underline{Q}$ des D-Flip-Flops mit einem Feldeffekttransistor FET verbunden. Parallel zu den Drain D und Source S Anschlüssen des Feldeffekttransistors FET liegt der Kondensator C der über den Widerstand R1 mit der Spannung U geladen wird. Ebenfalls mit dem Drain D Anschluß des Feldeffekttransistors FET ist ein erster Eingang K1 eines Komparators K verbunden. Ein zweiter Eingang K2 des Komparators K liegt am Mittenabgriff eines Spannungsteilers aus den Widerständen R2 und R3, der ebenfalls von der Spannung U versorgt wird. Der Ausgang des Komparators K ist mit dem negierenden Reset-Eingang R des D-Flip-Flops DF verbunden. Durch den Spannungsteiler liegt am Eingang K2 des Komparators K eine konstante Spannung von U/2 an. Befindet sich der Kondensator C im ungeladenen Zustand, so liegen am Eingang K1 des Komparators K O V an.

Wird durch einen ankommenden Impuls $P_T$ der Takteingang des D-Flip-Flops DF auf "high"-Pegel gesetzt, so liegt am Ausgang $\underline{Q}$ und damit auch am Gate G des Feldeffekttransistors FET ein Signal logisch "0" an. Der Feldeffekttransistors FET befindet sich damit im Sperrzustand, so daß der Kondensator C über den Widerstand R1 aufgeladen wird. Mit zunehmender Aufladung des Kondensators C steigt die Spannung am Eingang K1 des Komparators K an. Sobald diese Spannung ebenfalls den Wert U/2 erreicht, wird das Ausgangssignal des Komparators K invertiert und damit das D-Flip-Flop DF über seinen Reset-Eingang R zurückgesetzt. Der Ausgang $\underline{Q}$ des D-Flip-Flops DF und das Gate G des Feldeffekttransistors FET werden auf "high"-Pegel gesetzt wodurch der Drain-Source-Kanal D-S niederohmig wird, so daß der Kondensator C sich über den durchgeschalteten Feldeffekttransistor FET entlädt. Damit sind die Spannung am Eingang K1 des Komparators K wieder unter den Wert U/2 so daß das Ausgangssignal des Komparators und damit das Signal am Reset-Eingang R des D-Flip-Flops wieder invertiert wird und der Vorgang von vorne beginnt.

Durch dieses Wechselspiel zwischen Laden und Entladen des Kondensators C in Verbindung mit dem Komparator K können am Ausgang $\underline{Q}$ (oder wahlweise am Ausgang Q) Impulse IPB mit konstanter Impulsbreite abgegriffen werden. Für die Genauigkeit der Schaltung sind im wesentlichen der Kondensator C und die Widerstände R1 bis R3 verantwortlich. Bei entsprechender Wahl der Bauteile kann ein Driftfehler der Schaltung über einen Temperaturbereich von 50° K von einem 1 ‰ erreicht werden. Der Temperaturkoeffizient von Widerstand und Kondensator sollte nicht größer sein als 15 ppM/K (Part per million/Kelvin). Der konstante Fehler der im wesentlichen durch herstellungstechnische Mängel des Kondensators C bedingt ist, liegt unter 5 %.

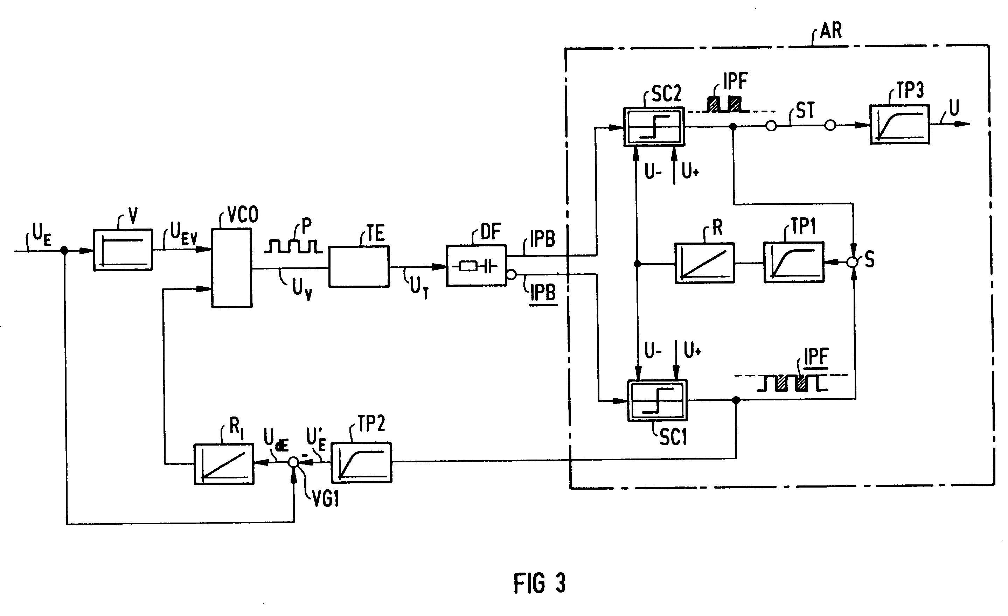

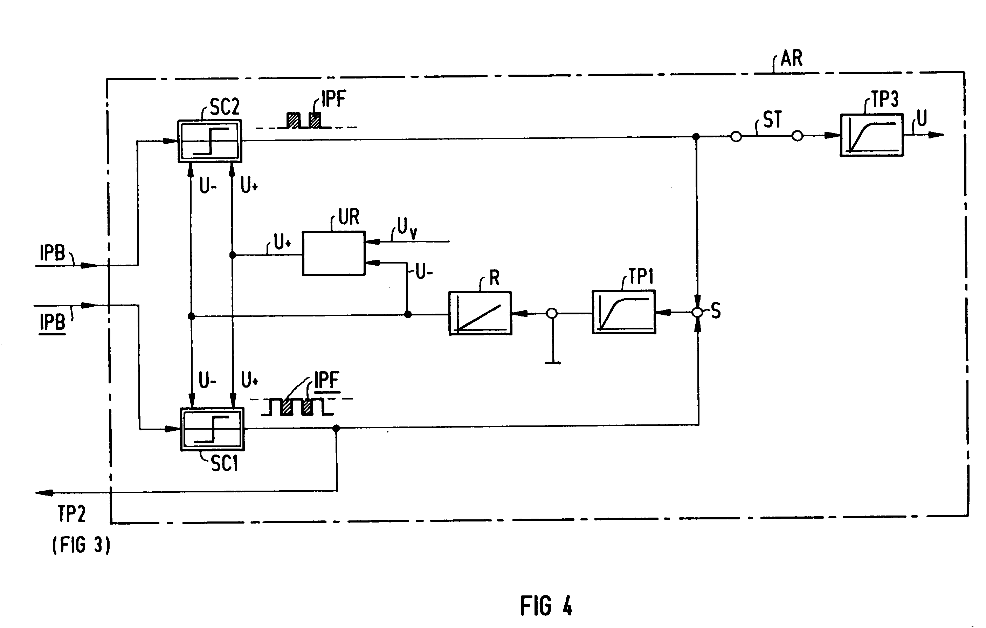

FIG 3 zeigt ein Blockschaltbild einer Einrichtung zur Spannungs-Frequenz-Wandlung mit analoger Auswertung. Der Verstärker V, der integrierende spannungsgesteuerte Oszillator VCO und der Frequenzteiler TE sind bereits aus FIG 1 bekannt. Der Regelkreis zur Regelung des spannungsgesteuerten Oszillators VCO enthält jetzt anstelle des Impulszählers IZ (FIG 1) und des Oszillators OS (FIG 1) das in FIG 2 beschriebene D-Flip-Flop DF. Die Reihenschaltung aus einem Widerstand und einem Kondensator in Block des D-Flip-Flops DF soll symbolisieren, daß die Zeitdauer der Präzisionsimpulse IPB bzw. $\underline{IPB}$ an den Ausgängen des D-Flip-Flops von der Zeitkonstante des RC-Gliedes abhängig ist. Die weiteren zur Regelstrecke des VCO gehörenden Mittel sind ebenfalls bereits aus FIG 1 bekannt: Der Schalter SC aus FIG 1 ist in FIG 3 mit SC1 bezeichnet, der Tiefpaß TP aus FIG 1 ist in FIG 3 mit TP2 bezeichnet. Die Bezeichnungen des Vergleichers VG1 und des Hauptreglers $R_I$ wurden beibehalten. Die Regelstrecke zur Regelung des spannungsgesteuerten Oszillators VCO unterscheidet sich in ihrer Wirkungsweise nicht von der bereits anhand der FIG 1 beschriebenen Wirkungsweise.

Im Gegensatz zur diskontinuierlichen bzw. digitalen Auswertung des Ausgangssignals $U_V$ des spannungsgesteuerten Oszillators VCO, die anhand der FIG 1 beschrieben wurde, soll jetzt das diskontinuierliche Frequenzsignal über die Übertragungsstrecke ST übertragen und anschließend analog weiterverarbeitet werden. Für die analoge Weiterverarbeitung werden aber hohe Anforderungen an die Qualität der Impulse P, insbesondere an deren Ein- und Ausschaltflanken, gestellt. Die Konstanz der Spannungszeitflächen des Pulspausensignals muß selbst bei hohen Impulsfolgefrequenzen noch gewährleistet sein. Die Impulsflanken müssen bei der analogen Auswertung eine Genauigkeit von 1 ‰ aufweisen. Deshalb muß das Ausgangssignal $U_V$ des spannungsgesteuerten Oszillators VCO für die analoge Weiterverarbeitung aufbereitet werden.

Diesem Zweck dient die gestrichelt umrandete Einrichtung zur Aufbereitung der Analogauswertung, im folgenden kurz Analogregeleinrichtung AR genannt.

Das nichtinvertierte Ausgangssignal IPB und das invertierte Ausgangssignal $\underline{IPB}$ des D-Flip-Flops DF wird jeweils auf einen Präzisionsschalter SC1 (dieser Schalter ist gleichzeitig Bestandteil der Regelstrecke für des VCO) bzw. SC2 geführt. Am Ausgang des Schalters SC2 entsteht das Signal der Präzisionsimpulse IPF mit konstantem Flächeninhalt und am Ausgang des Schalters SC1 entsteht das zum Ausgang des Schalters SC2 invertierte Signal. Das invertierte und das nichtinvertierte Signal werden am Summierer S addiert und das Additionsergebnis wird über einen Tiefpaß TP1 und über einen Regler R, der ein I-Regler sein kann, zur Regelung einer Versorgungsspannung - im gezeigten Fall der negativen Versorgungsspannung U_ - der Schalter SC1 und SC2 gegeben. Dadurch werden die Schalter SC1 und SC2 so geregelt, daß der Flächeninhalt eines jeweiligen positiven und negativen (invertierten) Präzisionsimpulses IPF, $\underline{IPF}$ gleich groß ist. Somit werden Abweichungen der Ein- und Ausschaltflanken der Präzisionsimpulse IPF, $\underline{IPF}$ kompensiert. Das so geregelte Signal der Präzisionsimpulse IPF kann dann über die Übertragungsstrecke ST auf den Tiefpaß TP3 gegeben werden, der das Signal für eine analoge Weiterverarbeitung als Gleichspannung U an seinem Ausgang zur Verfügung stellt.

FIG 4 zeigt das Blockschaltbild einer weiteren Analogregeleinrichtung AR. Zusätzlich zu der bereits aus FIG 3 bekannten Analogregeleinrichtung AR enthält die Analogregeleinrichtung AR gemäß FIG 4 eine Spannungsreferenzquelle UR mit der auch die positive Versorgungsspannung U+ der Präzisionsschalter SC1, SC2 geregelt wird. Die Referenzspannungsquelle UR wird mit einer Versorgungsspannung UV beaufschlagt und erhält die negative Spannung U- vom Ausgang des Reglers R. Der Eingang des Reglers R ist auf Nullpotential gelegt. Durch diese Beschaltung wird erreicht, daß die Summe der Beträge der negativen und der positiven Versorgungsspannung U-/U+ der Präzisionsschalter SC2, SC1 konstant ist und daß die Versorgungsspannungen U-/U+ symmetrisch um eine vorgegebene Mittelpunktspannung, vorzugsweise Massepotential liegen.

Bedingt durch die Frequenzteilung des Ausgangssignales $U_V$ des spannungsgesteuerten Oszillators mittels des Frequenzteilers TE sind die in der Analog-Regeleinrichtung AR erzeugten Präzisionsimpulse IPF/IPF so genau, daß ohne zusätzliche Maßnahmen eine hochgenaue analoge Auswertung über den Tiefpaß TP3 erfolgen kann.

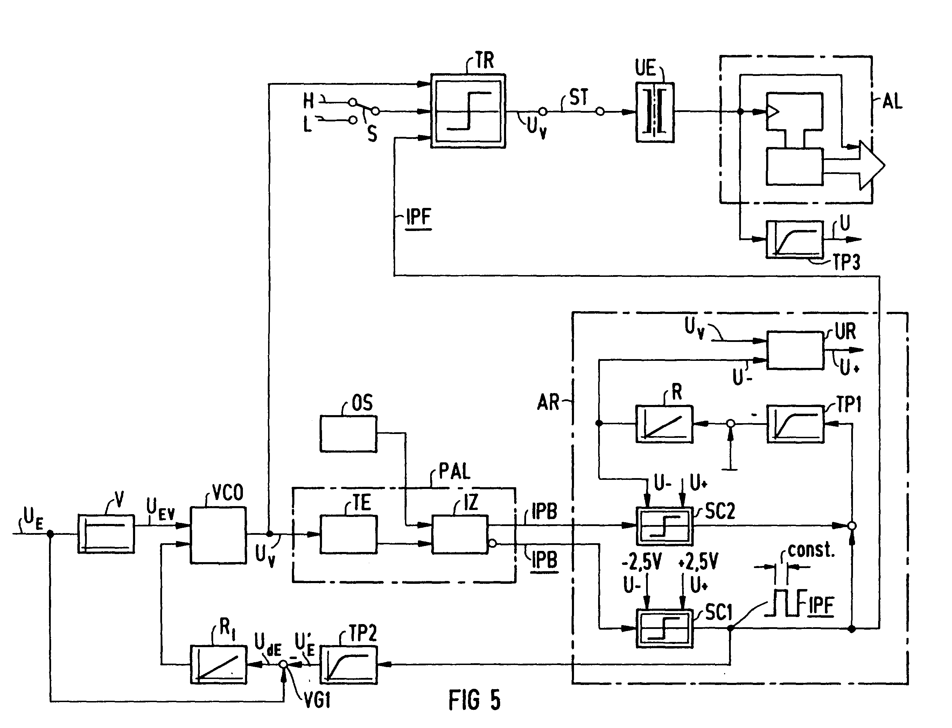

Das Blockschaltbild gemäß FIG 5 zeigt eine Einrichtung zur Spannungs-Frequenz-Wandlung mit wahlweiser digitaler oder analoger Signal-Weiterverarbeitung. Dieses Blockschaltbild ist im wesentlichen eine Zusammenfassung der bereits aus FIG 1 und FIG 4 bekannten Einrichtungen. Zur Erzeugung des Präzisionsimpulses IPF, IPB konstanter Pulsbreite wurde wahlweise der Impulszähler IZ mit dem Ozillator OS verwendet. Für die digitale Weiterverarbeitung wird das Ausgangssignal $U_V$ des spannungsgesteuerten Oszillators VCO über den Treiber TR und die Übertragungsstrecke ST an die Auswertelogik AL geführt. Durch einen Übertrager UE, der wahlweise vor oder hinter der Übertragungsstrecke ST angeordnet sein kann, kann das Signal galvanisch entkoppelt werden. Zur digitalen Auswertung enthält die Auswertelogik AL einen binären Zähler der die Impulse des spannungsproportionalen digitalen Signals $U_V$ während einer vorgegebenen Periode zählt und als binärcodierten Zahlenwert an ein Bussystem gibt. Da die niederwertigste Binärstelle genau der halben Frequenz des Zählereingangsignals $U_V$ entspricht, kann dieses Signal direkt als Ausgangssignal des Zählers verwendet werden und somit die Auflösung des Zählers verdoppelt werden. (dieses Prinzip ist Gegenstand der älteren europäischen Patentanmeldung 90 108 326.1 "Digitale Zählschaltung", die als EP-A-0 454 882 am 6. November 1991 nach dem Anmeldetag veröffentlicht ist). Dies entspricht in seiner Wirkung einer Verdopplung des Frequenzhubes des spannungsgesteuerten Oszillators VCO.

Für eine analoge Weiterverarbeitung braucht lediglich der Schalter S umgelegt zu werden, so daß der Treiber TR anstelle des Signals $U_V$ die geregelten Präzisionsimpulse an seinen Ausgang weitergibt. Die Analog-Regeleinrichtung AR entspricht genau der in FIG 2 beschriebenen.

Bei der digitalen Auswertung werden die Impulse P des Ausgangssignals $U_V$ des spannungsgesteuerten Oszillators VCO in einem bestimmten Zeitintervall gezählt. Für die Auswertung ist es besonders vorteilhaft, die Impulse in einem vorgegebenen Zeitintervall zu zählen und diese Zählung in einem kürzeren Zeitintervall periodisch zu wiederholen. Diese Auswertung kann als "gleitendes Fenster" bezeichnet werden. Beispielsweise könnte die Anzahl der Impulse P während eines Zeitraums von T = 100 msec. gezählt werden, wobei die Zählung jeweils periodisch im Abstand von 5 msec. durchgeführt wird.

Die Übertragung einer hohen Pulsfolgefrequenz (beispielsweise 40 MHz) über die Treiberstufe TR und die Übertragungsstrecke ST an die Auswertelogik AL, ist für die digitale Auswertung unkritisch, da an die Impulsform der Impulse P nur geringe Ansprüche gestellt werden, so daß die Qualität des Verfahrens durch eine "Verschleifung" der Impulse P nicht beeinträchtigt wird, solange die Impulse P von der Auswertelogik AL gerade noch erkannt werden können. Falls tatsächlich ein Impuls P nicht mehr erkannt werden sollte, entsteht kein bleibender Fehler, da lediglich die Genauigkeit einer Zählung während einer Zeiteinheit beeinflußt wird. Das Verfahren weist demnach eine hohe Störsicherheit auf.

## Patentansprüche

1. Verfahren zur Spannungs-Frequenz-Wandlung nach folgenden Verfahrensschritten:

   a) Ein integrierender, spannungsgesteuerter Oszillator (VCO) wird mit einer Eingangsspannung ($U_E$) beaufschlagt, die über eine Pegelanpaßschaltung (V) führbar ist,
   b) das Ausgangssignal ($U_V$) des spannungsgesteuerten Oszillators (VCO) wird einem Frequenzteiler (T) zugeführt,
   c) die Einzelimpulse ($P_T$) des Ausgangssignals ($U_T$) des Frequenzteilers (T) werden in eine Impulsfolge mit konstanter Pulsbreite (IPB) gewandelt und anschließend in ihrer Amplitude so geregelt, daß Impulse mit konstantem Flächeninhalt (F) als Präzisionsimpulse (IPF) erzeugt werden,

   **dadurch gekennzeichnet**, daß

   d) aus den Präzisionsimpulsen (IPF) eine Gleichspannung ($U'_E$) gebildet wird,
   e) aus der Gleichspannung ($U'_E$) und der Eingangsspannung ($U_E$) eine Differenzspannung ($U_{dE}$) gebildet wird, die dem spannungsgesteuerten Oszillator (VCO) über einen Regler ($R_i$) zur Regelung aufgeschaltet wird.

2. Verfahren nach Anspruch 1, **dadurch gekennzeichnet**, daß die Impulsfolge mit konstanter Pulsbreite (IPB) mit einem Impulszähler (IZ) erzeugt wird, wobei der Impulszähler (IZ) während einer vorgebbaren Anzahl von Zählertaktsignalen ein Ausgangssignal ($U_R$) logisch "1" abgibt.

3. Verfahren nach Anspruch 2, **dadurch gekennzeichnet**, daß das Zählertaktsignal (ZT) von einem Quarzoszillator abgeleitet wird.

4. Verfahren nach Anspruch 2, **dadurch gekennzeichnet**, daß das Zählertaktsignal von einem RC-Glied abgeleitet wird.

5. Verfahren nach Anspruch 1, **dadurch gekennzeichnet**, daß die Impulsfolge mit konstanter Pulsbreite (IPB) mit einem getakteten, bistabilen Schalter (MF) erzeugt wird, wobei das Taktsignal des bistabilen Schalters (MF) aus einem RC-Glied abgeleitet wird.

6. Verfahren nach einem der Ansprüche 1 bis 5, **dadurch gekennzeichnet**, daß zu den Präzisionsimpulsen (IPF) invertierte Präzisionsimpulse (IPF) erzeugt werden, wobei aus der Summe der Spannungen der Präzisionsimpulse (IPF) und der invertierten Präzisionsimpulse (IPF) eine Regelgröße gebildet wird, mit der eine jeweilige Versorgungsspannung (U_) der Einrichtungen (SC1,SC2,MF) zur Erzeugung der Präzisionsimpulse (IPF,IPF), so geregelt wird, daß die Spannungs-Zeit-Flächen eines jeweiligen Präzisionsimpulses (IPF) und eines jeweiligen invertierten Präzisionsimpulses (IPF) gleich sind.

7. Verfahren nach Anspruch 6, **dadurch gekennzeichnet**, daß sowohl die positive als auch die negative Versorgungsspannung (U+,U-) der jeweiligen Einrichtungen (SC1,SC2,MF) zur Erzeugung der Präzisionsimpulse (IPF,IPF) so geregelt werden, daß die Summe ihrer Beträge konstant ist und die Präzisionsimpulse (IPF,IPF) symmetrisch um eine vorgebbare Mittelpunktsspannung liegen.

8. Verfahren nach Anspruch 6 oder 7, **dadurch gekennzeichnet**, daß die geregelten Präzisionsimpulse (IPF) oder die geregelten invertierten Präzisionsimpulse (IPF) über eine Übertragungsstrecke übertragen und anschließend in eine Gleichspannung (U) umgewandelt werden.

9. Verfahren nach einem der Ansprüche 1 bis 5, **dadurch gekennzeichnet**, daß die Impulse (P) des Ausgangssignals ($U_V$) des integrierenden, spannungsgesteuerten Oszillators (VCO) in einer Auswertelogik (AL) in einem vorgebbaren Zeitraum mit vorgebbarer Periode gezählt werden.

10. Verfahren nach Anspruch 9, **dadurch gekennzeichnet**, daß die Auswertelogik (AL) einen digitalen Zähler enthält, wobei als Taktsignal des Zählers jeweils die positive und negative Flanke eines Pulses ($P_V$) des Ausgangssignals ($U_V$) des spannungsgesteuerten Oszillators (VCO) verwendet.

11. Verfahren nach Anspruch 9, **dadurch gekenn**

**zeichnet**, daß die Auswertelogik (AL) einen digitalen Zähler enthält, wobei der Zähler mit dem Ausgangssignal ($U_V$) des spannungsgesteuerten Oszillators (VCO) getaktet wird und wobei das Ausgangssignal des spannungsgesteuerten Oszillators (VCO) als eine weitere Binärstelle darstellendes Ausgangssignal zu den Ausgangssignalen des Zählers verwendet wird.

**Claims**

1. Method for voltage frequency transformation according to the following method steps:

   a) an input voltage ($U_E$) which can be passed by way of a level adjustment circuit (V) is applied to an integrating, voltage-controlled oscillator (VCO);
   b) the output signal ($U_V$) of the voltage-controlled oscillator (VCO) is passed to a frequency divider (T [sic]);
   c) the individual impulses ($P_T$) of the output signal ($U_T$) of the frequency divider (T [sic]) are transformed into an impulse sequence with a constant pulse width (IPB) and subsequently regulated in their amplitude in such a way that impulses with a constant area content (F) are generated as precision impulses (IPF),

   **characterised in that**

   d) a constant voltage ($U'_E$) is generated from the precision impulses (IPF),
   e) from the constant voltage ($U'_E$) and the input voltage ($U_E$) there is formed a difference voltage ($U_{dE}$) which is applied to the voltage-controlled oscillator (VCO) for control, by way of a controller ($R_1$).

2. Method according to claim 1, characterised in that the impulse sequence with a constant pulse width (IPB) is generated using an impulse counter (IZ), where the impulse counter (IZ) gives off a logic "1" output signal ($U_R$ [sic]) during a preset number of counter clock signals.

3. Method according to claim 2, characterised in that the counter clock signal (ZT) is derived from a quartz oscillator.

4. Method according to claim 2, characterised in that the counter clock signal is derived from an RC element.

5. Method according to claim 1, characterised in that the impulse sequence with a constant pulse width (IPB) is generated in a clocked bistable switch (MF), where the clock signal of the bistable switch (MF) is derived from an RC element.

6. Method according to one of claims 1 to 5, characterised in that inverted precision impulses (IFP) are generated for the precision impulses (IPF), where a control value is formed from the total of the precision impulses (IPF) and the inverted precision impulses (IPF), which control value controls a respective supply voltage (U-) of the devices (SC1, SC2, MF) to generate the precision impulses (IPF, IPF) in such a way that the voltage time areas of a respective precision impulse (IPF) and of a respective inverted precision impulse (IPF) are equal.

7. Method according to claim 6, characterised in that both the positive and the negative supply voltages (U+, U-) of the respective devices (SC1, SC2, MF) for generating the precision impulses (IPF, IPF) are controlled in such a way that the total of their amounts is constant and the precision impulses (IPF, IPF) lie symmetrically around a preset median voltage.

8. Method according to claim 6 or 7, characterised in that the regulated precision impulses (IPF) or the regulated inverted precision impulses (IPF) can be transmitted by way of a transmission segment and subsequently transformed into a constant voltage (U).

9. Method according to one of claims 1 to 5, characterised in that the impulses (P) of the output signal ($U_V$) of the integrating, voltage-controlled oscillator (VCO) are counted in a evaluation logic (AL), during a preset time span, with a preset period.

10. Method according to claim 9, characterised in that the evaluation logic (AL) contains a digital counter, where the positive edge and the negative edge of a pulse ($P_V$) of the output signal ($U_V$) of the voltage-controlled oscillator (VCO) are respectively used as the clock signal of the counter.

11. Method according to claim 9, characterised in that the evaluation logic (AL) contains a digital counter, where the counter is clocked with the output signal ($U_V$) of the voltage-controlled oscillator (VCO), and where the output signal of the voltage-controlled oscillator (VCO) is used as an output signal which represents an additional binary position relative to the output signals of the counter.

**Revendications**

1. Procédé de conversion tension-fréquence suivant les étapes opératoires suivantes :

a) on applique à un oscillateur (VCO) intégrateur commandé par tension une tension ($U_E$) d'entrée, qui est amenée par l'intermédiaire d'un circuit (V) d'adaptation de niveau,
b) on envoie le signal ($U_V$) de sortie de l'oscillateur (VCO) commandé par tension à un diviseur (T) de fréquence,
c) on convertit les impulsions individuelles ($P_T$) du signal ($U_T$) de sortie du diviseur (T) de fréquence en un train d'impulsions de largeur d'impulsion (IPB) constante puis on régule son amplitude, de sorte à produire des impulsions d'aire (F) constante en tant qu'impulsions (IPF) de précision,

caractérisé en ce que

d) on forme à partir des impulsions (IPF) de précision une tension ($U'_E$) continue,
e) on forme à partir de la tension ($U'_E$) continue et de la tension ($U_E$) d'entrée une tension ($U_{dE}$) de différence, qui est envoyée à l'oscillateur (VCO) commandé par tension par l'intermédiaire d'un régulateur ($R_i$) pour la régulation.

2. Procédé suivant la revendication 1, caractérisé en ce que l'on produit le train d'impulsion de largeur (IPB) d'impulsion constante par un compteur (IZ) d'impulsion, le compteur (IZ) d'impulsion fournissant pendant un nombre pouvant être prescrit de signaux de cadence de compteur un signal ($U_R$) de sortie "1" logique.

3. Procédé suivant la revendication 2, caractérisé en ce que le signal (ZT) de cadence de compteur est obtenu à partir d'un oscillateur à quartz.

4. Procédé suivant la revendication 2, caractérisé en ce que le signal de cadence de compteur est obtenu à partir d'un élément RC.

5. Procédé suivant la revendication 1, caractérisé en ce que le train d'impulsions de largeur IPB d'impulsion constante est produit par un interrupteur (MF) cadencé bistable, le signal de cadence de l'interrupteur bistable (MF) étant obtenu à partir d'un élément RC.

6. Procédé suivant l'une des revendications 1 à 5, caractérisé en ce que l'on produit des impulsions (IPF) de précision inversées par rapport aux impulsions (IPF) de précision, on forme à partir de la somme des tensions des impulsions (IPF) de précision et des impulsions (IPF) de précision inversées une grandeur réglée, par laquelle on régule une tension (U_) d'alimentation des dispositifs (SC1, SC2, MF) de production des impulsions (IPF, IPF) de précision de telle sorte que les intégrales de tension en fonction du temps de chaque impulsion (IPF) de précision et de chaque impulsion ($\underline{\text{IPF}}$) de précision inversée soit égale.

7. Procédé suivant la revendication 6, caractérisé en ce que l'on régule à la fois la tension d'alimentation positive et la tension d'alimentation négative (U+, U-) des dispositifs (SC1, SC2, MF) de production des impulsions (IPF, $\underline{\text{IPF}}$) de précision, de telle sorte que la somme de leurs modules soit constante et que les impulsions (IPF, $\underline{\text{IPF}}$) de précision soient symétriques par rapport à une tension médiane pouvant être prescrite.

8. Procédé suivant la revendication 6 ou 7, caractérisé en ce que les impulsions (IPF) de précision régulées ou les impulsions ($\underline{\text{IPF}}$) de précision inversées régulées sont transmises par l'intermédiaire d'une voie de transmission puis sont converties en une tension continue (U).

9. Procédé suivant l'une des revendications 1 à 5, caractérisé en ce que l'on compte les impulsions (P) du signal ($U_V$) de sortie de l'oscillateur (VCO) intégrateur commandé par tension dans un dispositif (AL) logique d'exploitation pendant un laps de temps pouvant être prescrit à une période pouvant être prescrite.

10. Procédé suivant la revendication 9, caractérisé en ce que le dispositif (AL) logique d'exploitation comprend un compteur numérique, le flanc positif et le flanc négatif d'une impulsion ($P_V$) du signal ($U_V$) de sortie de l'oscillateur (VCO) commandé par tension étant utilisé comme signal de cadence du compteur.

11. Procédé suivant la revendication 9, caractérisé en ce que le dispositif (AL) logique d'exploitation comporte un compteur numérique, le compteur étant cadencé par le signal ($U_V$) de sortie de l'oscillateur (VCO) commandé par tension et le signal de sortie de l'oscillateur (VCO) commandé par tension étant utilisé comme signal de sortie représentant un chiffre binaire supplémentaire par rapport aux signaux de sortie du compteur.

FIG 1

FIG 2

FIG 3

FIG 4

(FIG 3)

FIG 5